Europäisches Patentamt

European Patent Office

Office européen des brevets

(19)

(11) Publication number: 0 354 671
A1

# EUROPEAN PATENT APPLICATION

(21) Application number: 89307298.3

(22) Date of filing: 19.07.89

(51) Int. Cl.4: H01P 3/08 , H01P 11/00

(30) Priority: 19.07.88 US 221395

(43) Date of publication of application:
14.02.90 Bulletin 90/07

(84) Designated Contracting States:
AT BE CH DE ES FR GB GR IT LI LU NL SE

(71) Applicant: THE REGENTS OF THE UNIVERSITY
OF CALIFORNIA
300 Lakeside Drive 22nd Floor
Oakland California 94612-3550(US)

(72) Inventor: Tuckerman, David B.
5228 Felicia Avenue
Livermore California 94550(US)

(74) Representative: Cross, Rupert Edward Blount
et al
BOULT, WADE & TENNANT 27 Furnival Street
London EC4A 1PQ(GB)

(54) Stand-off transmission lines and methods for making same.

(57) Standoff transmission lines in an integrated circuit structure are formed by etching away or removing the portion of the dielectric layer separating the microstrip metal lines and the ground plane from the regions that are not under the lines. The microstrip lines can be fabricated by a subtractive process of etching a metal layer, an additive process of direct laser writing fine lines followed by plating up the lines or a subtractive/additive process in which a trench is etched over a nucleation layer and the wire is electrolytically deposited. Microstrip lines supported on freestanding posts of dielectric material surrounded by air gaps are produced. The average dielectric constant between the lines and ground plane is reduced, resulting in higher characteristic impedance, less crosstalk between lines, increased signal propagation velocities, and reduced wafer stress.

FIG. 2

## STAND-OFF TRANSMISSION LINES AND METHODS FOR MAKING SAME

The United States Government has rights in this invention pursuant to Contract No. W-7405-ENG-48 between the U. S. Department of Energy and the University of California, for the operation of Lawrence Livermore National Laboratory.

BACKGROUND OF THE INVENTION

The invention relates to microstrip transmission lines in integrated circuits and methods of making same.

In a conventional microstrip transmission line geometry in an integrated circuit structure, a dielectric layer is formed over a ground plane and spaced metal microstrip lines are formed on the dielectric layer. This conventional transmission line geometry, in which the metal lines stand on the entire dielectric plane, has problems of low characteristic impedance due to fringing fields, low signal propagation velocity due to the reduced "speed of light" in the dielectric, and high wafer stress due to thermal expansion mismatch between the dielectric layer and the metal ground plane.

It is desirable to provide a microstrip transmission line geometry with higher characteristic impedance, lower fringing fields, less capacitive coupling and crosstalk, increased signal propagation velocities, and lower wafer stress than presently available. Such an improved microstrip transmission line geometry would greatly enhance integrated circuit performance.

SUMMARY OF THE INVENTION:

Accordingly it is an object of the invention to provide an improved microstrip transmission line geometry, and methods for making same.

It is also an object of the invention to provide a microstrip transmission line geometry with higher characteristic impedance and lower fringing fields.

It is another object of the invention to provide a microstrip transmission line geometry with less capacitive coupling and cross talk.

It is a further object of the invention to provide a microstrip transmission line geometry with increased signal propagation velocities.

It is also an object of the invention to provide a microstrip transmission line geometry with lower wafer stress.

The invention is a stand-off transmission line geometry, in which metal microstrip lines stand only on a post of dielectric between the metal and ground plane. The stand-off transmission lines are produced by first forming a dielectric layer on a metal ground plane and forming the metal lines on the dielectric layer (as in the conventional microstrip transmission line geometry). The metal lines can be formed by any suitable process, including a subtractive process using a series of masks to form metal lines from a metal layer, an additive process to deposit very thin metal lines which are then plated up, and a quasi-additive method in which a pattern of trenches is formed to expose a metal surface to nucleate subsequent electrolytic deposition of metal lines. The metal patterns (lines) can be defined using conventional photoresist techniques or laser techniques or any other known method.

The dielectric in the regions outside the metal lines is then removed down to the ground plane so that the only remaining dielectric is a post underneath each metal line. The stand-off lines can be fabricated by reactive ion etching (RIE) of the dielectric using the metal lines as a mask pattern (i.e., a self-aligned process). Alternatively, it may also be desirable or necessary to enhance the selectivity of the etching process by placing another mask of material on top of the metal lines, e.g. carbon. Typically, the dielectric is $SiO_2$, but a polyimide or other dielectric could also be used. Any other dielectric removal process which leaves the dielectric only under the metal lines could be used, e.g. ion milling or other directional etching process.

It is possible to fabricate two or more levels of metal transmission lines by first forming the complete sequence of dielectric layers and metal lines on each dielectric layer and then anisotropically etching the dielectric away. In this process dielectric will be removed only to the topmost metal line so that only regions over which no metal lines cross will be etched down to the ground plane.

The stand-off configuration has four obvious benefits: (1) higher characteristic impedance due to reduced fringing fields, (2) somewhat less crosstalk due to reduced capacitive coupling between lines, (3) increased signal propagation velocities due to the reduced average dielectric constant, and (4) less stress in the wafer from thermal expansion mismatch between the dielectric and the substrate. These effects are highly desirable in computer system applications. The higher characteristic impedance can lead to less attenuation per unit length.

BRIEF DESCRIPTION OF THE DRAWING:

Figure 1 is a sectional view of a prior art microstrip transmission line geometry.

Figure 2 is a sectional view of a standoff transmission line geometry.

Figure 3 is a flow chart of a subtractive process for forming metal wires on a substrate using photoresist.

Figure 4 is a flow chart of a subtractive process for forming metal wires on a substrate using (laser) etching.

Figures 5A-F illustrate the steps of a quasi-additive or subtractive/additive process for forming metal wires on a substrate using photoresist.

Figures 6A-F illustrate the steps of a quasi-additive or subtractive/additive process for forming metal wires on a substrate using (laser) etching.

DETAILED DESCRIPTION OF THE INVENTION:

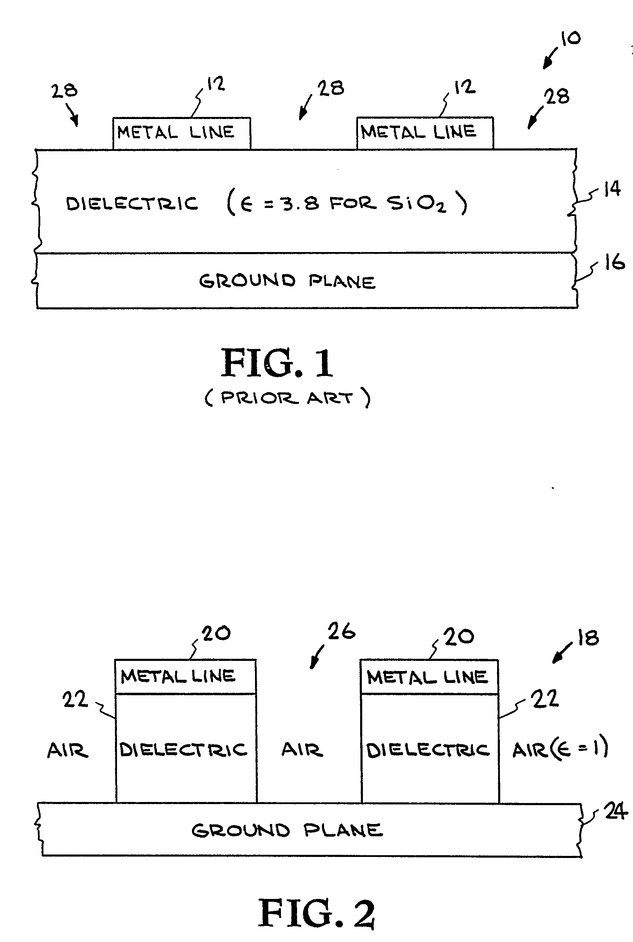

A conventional prior art microstrip transmission line structure 10 is illustrated in Figure 1. Spaced metal lines 12 are formed on a dielectric layer 14 which separates the metal lines from an underlying metal ground plane 16. The dielectric layer is an entire layer which covers the whole ground plane. For $SiO_2$ the dielectric constant is 3.8; this dielectric constant will thus determine the electrical properties of the transmission line structure.

A standoff microstrip transmission line structure 18 according to the invention is illustrated in Figure 2. Spaced metal microstrip lines 20 stand only on individual posts 22 of dielectric material between the metal lines and metal ground plane 24. The vertical dielectric posts 22 are separated by and define gaps or open regions 26 extending down to the ground plane 24 in the spaces around the metal lines 20. Thus the only dielectric material between the metal lines 20 and ground plane 24 is the vertical walls or posts 22 of width substantially the same as the metal lines 20. The remaining area above the ground plane 24, i.e. gaps or spaces 26, are filled with air, which has a dielectric constant of 1. Thus the combined or average dielectric constant between the metal lines and ground plane will be substantially reduced, and will therefore alter the electrical properties of the transmission line structure.

The standoff transmission line structure 18 is formed by first producing the prior art transmission line structure 10 having a dielectric layer 14 on metal ground plane 16 and metal lines 12 on dielectric layer 14, as was shown in Figure 1. The metal lines can be formed by a number of different processes as will be further explained below. The metal lines typically have a thickness of about 5 $\mu$m and the dielectric layer of about 10 $\mu$m. The metal lines are typically about 10-25 $\mu$m wide, with 20-40 $\mu$m spaces between them. The dielectric in the regions or spaces 28 not directly underneath the metal lines is then directionally removed down to the ground plane so that the only remaining dielectric is under the metal lines, forming the posts 22 separated or surrounded by air gaps 26 as shown in Figure 2.

The standoff lines can be fabricated by any dielectric removal process that leaves the metal lines on freestanding spaced dielectric posts under the metal lines. The dielectric is typically $SiO_2$, but could be polyimide or other material. A preferred method is reactive ion etching (RIE) of the dielectric. A self-aligned method can be utilized in which the metal lines themselves are used as a mask pattern for the RIE process. Alternatively, for enhanced selectivity of the etching process, another mask of a different material, e.g. carbon, may be placed on top of the metal lines for the RIE process, and later removed (if necessary). Other directional etching processes including ion milling could also be used.

A multilevel transmission line structure, having two or more levels of metal lines, can also be fabricated. After a structure like that of Figure 1 is produced to form the first level, additional layers of dielectric and metal lines are sequentially formed, producing multilevel transmission lines completely surrounded by solid dielectric over a single ground plane. Only after all the levels have been produced is the etching or removal of dielectric performed. Any underlying metal lines will form an etch stop so that only regions of the ground plane over which no metal lines cross will be exposed. Thus, only the dielectric needed to support the metal lines will remain, with open spaces in the structure down to the topmost metal line at any point in the structure, so that the combined or average dielectric constant will be considerably reduced and the electrical properties of the structure significantly improved.

Prior to etching away the unnecessary dielectric material metal lines are formed on a dielectric layer. These metal lines can be formed by a number of different processes, including a subtractive process and a quasi-additive or subtractive/additive process. These transmission line fabrication processes can be implemented using laser pantography techniques or with photoresist or by any other known process.

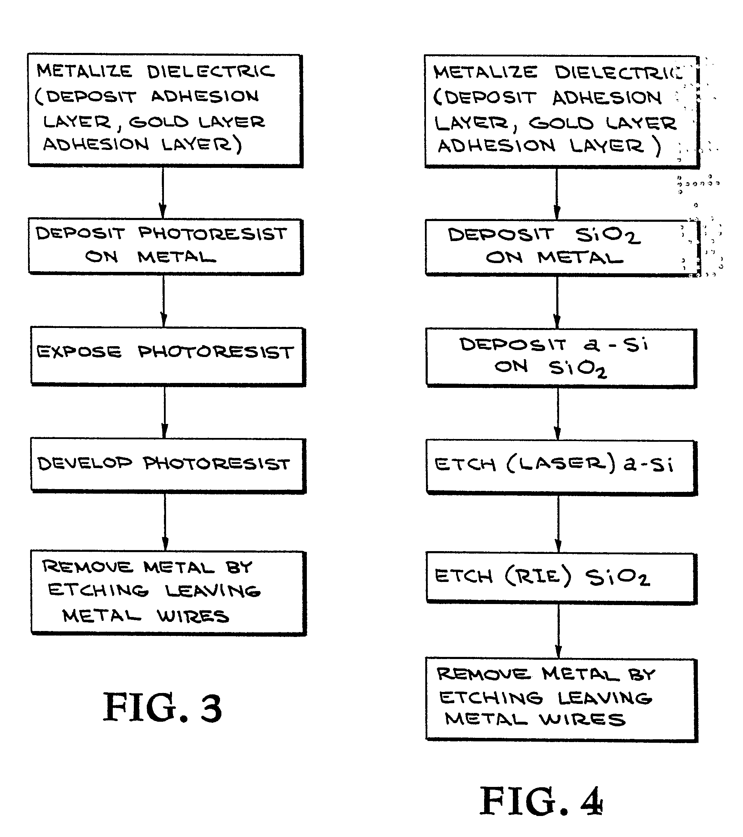

A subtractive process, illustrated in the flow chart of Figure 3, forms the metal wires using photoresist to pattern a metal layer. The dielectric layer is first metallized, e.g. with approximately 3 $\mu$m of gold (over a barrier or adhesion layer, e.g. Ti:W). The metal layer is then coated with photoresist, which can be patterned using conventional techniques. The photoresist layer is exposed using a photolithography mask, and then developed. The unexposed photoresist covers the portion of the metal layer which forms the wires. The photoresist mask is then used to remove the rest of the metal layer by any suitable etching or other process, leaving the metal transmission lines. The remaining photoresist can then be removed.

An alternative subtractive process, illustrated in the flow chart of Figure 4, forms the metal wires by a series of etching steps. The dielectric layer is metallized, e.g. with approximately 3 $\mu$m of gold (over a barrier or adhesion layer, e.g. Ti:W), then overcoated with at least one mask layer, e.g. with $SiO_2$ and then a-Si. In one specific embodiment, the metal layer is overcoated with approximately 3 $\mu$m of $SiO_2$, e.g. using plasma-enhanced chemical vapor deposition (PECVD). The $SiO_2$ is coated with an inorganic mask of amorphous silicon (a-Si) using PECVD; other materials such as carbon could be used. The a-Si/$SiO_2$ laminate is then laser etched and reactive ion etched to generate an inorganic mask for the metallization (to remove all the metal except for the desired wires). The a-Si is locally etched, preferably by a laser, e.g. by irradiating it in a 760-torr chlorine gas ambient with a computer-controlled argon-ion laser beam, acoustooptically scanned at 3 mm/sec and 300 mU power, focused to a 5-um spot diameter. The etched pattern is transferred to the underlying $SiO_2$ by reactive-ion etching (RIE) or other suitable process such as plasma etching or wet chemical etching. The a-Si mask is then plasma-stripped. The $SiO_2$ pattern is transferred to the gold by ion milling or other etching techniques such as electropolishing, plasma etching or wet chemical etching, removing all metal from undesired areas and leaving the metal wires (transmission lines).

The invention also includes a quasi-additive or subtractive/additive process for forming metal lines using either photoresist or laser patterning. According to the invention the areas where metal is desired are defined by exposing photoresist or by laser etching a pattern to expose a metal surface which is then used to nucleate subsequent electroplating or electroless plating to form a metal line of desired size.

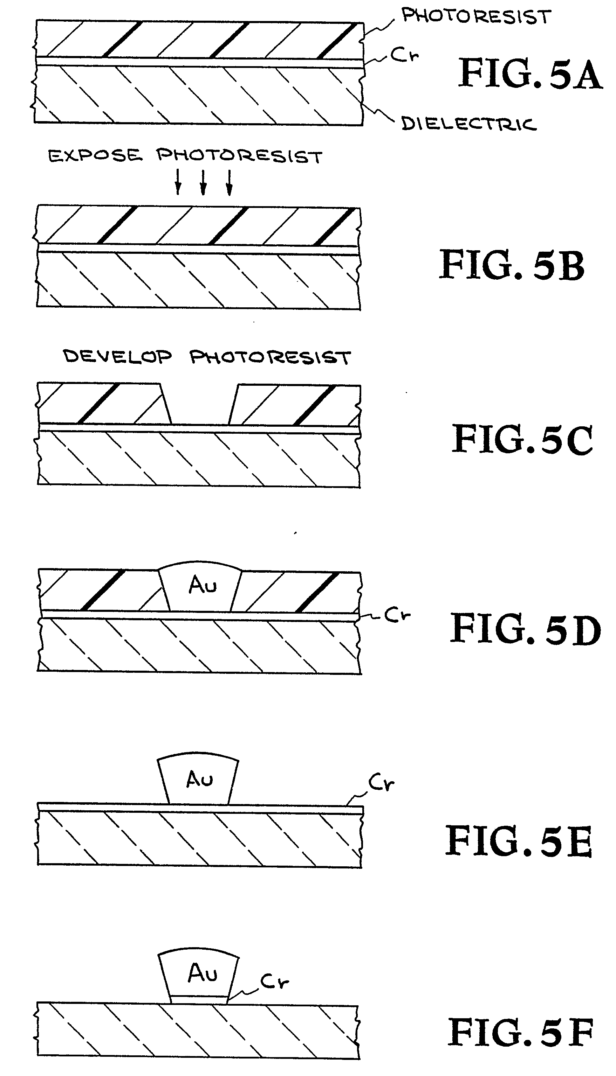

An illustrative process using photoresist to form metal lines is shown in Figures 5A-F. First a thin metal layer, e.g. Cr or other suitable metal, is formed on the dielectric substrate, and a layer of photoresist is applied to the Cr, as shown in Figure 5A. Second, as shown in Figure 5B, the photoresist is exposed, using suitable masks, in a pattern defining the desired lines. Third, the exposed photoresist is developed, forming a trench which exposes the Cr layer where the lines are desired as shown in Figure 5C. Fourth, as shown in Figure 5D, a metal wire is built up using electroplating or electroless plating with the exposed Cr acting as a nucleation site. Typically gold or copper lines can be formed. For the vertical side to be relatively smooth, the photoresist layer must be as thick as the desired line so that the line is conformal. Fifth, after the metal wire has been built up to its desired height, the surrounding photoresist is removed, as shown in Figure 5E, leaving a metal line on the Cr layer. Finally, as shown in Figure 5F, the exposed Cr layer surrounding the metal line is etched away, leaving a freestanding metal line formed on the dielectric.

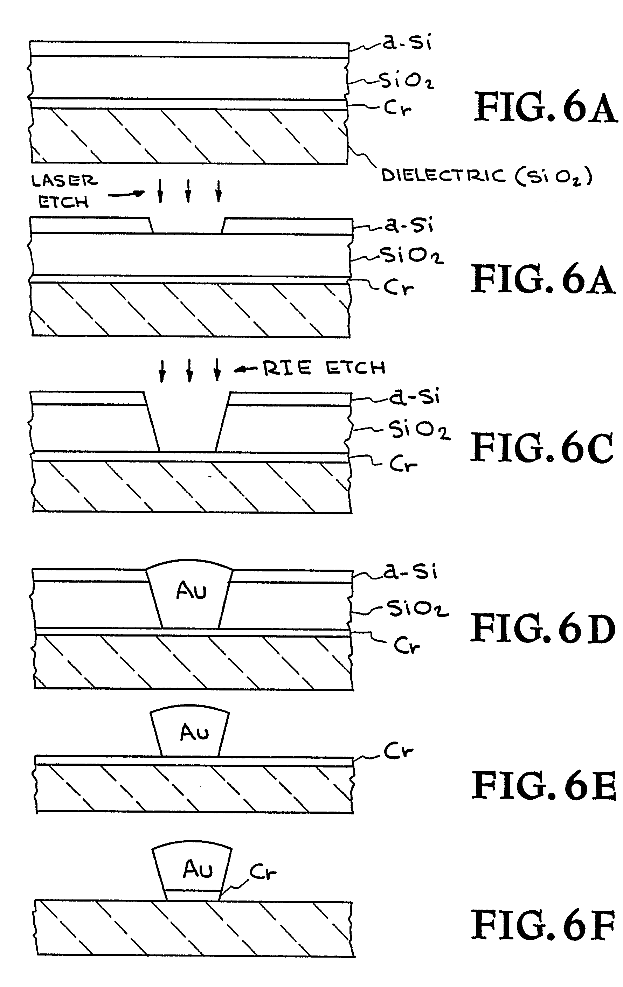

An illustrative specific sequence which could be used to form metal lines using laser patterning techniques is shown in Figures 6A-F. In the first step, as shown in Figure 6A, a series of layers, Dr, $SiO_2$, a-Si, are sequentially formed on the dielectric substrate. Other metals, e.g. Cu, Au, Ti, as well as other dielectric and mask materials could be used. The substrate is the dielectric layer between the lines and ground plane. In step two, as shown in Figure 6B, the a-Si layer is laser etched in a $Cl_2$ ambient; the laser etch process is a relatively fast process. In the third step, shown in Figure 6C, the laser-etched a-Si layer is used as a mask to wet chemical etch, plasma etch or reactive ion etch (RIE) the $SiO_2$ layer, using the Cr layer as an etch stop. Thus, a trench is formed down to the Cr layer which corresponds to the desired metal line position. In step four, as shown in Figure 6D, a metal wire is built up using electroless plating or electroplating with the exposed Cr at the bottom of the trench serving as a nucleation site. Typically gold or copper lines can be formed. For the vertical side to be be relatively smooth, the a-Si/$SiO_2$ layer must be as thick as the desired line so that the line is conformal. In step five, as shown in Figure 6E, once the metal wire has been built up to its desired height, the surrounding a-Si and $SiO_2$ layers are plasma etched away, leaving a metal line standing on the Cr layer. In the sixth and final step, shown in Figure 6F, the exposed Cr layer surrounding the metal line is etched away leaving a free standing metal line formed on the dielectric substrate.

Changes and modifications in the specifically described embodiments can be carried out without departing from the scope of the invention which is intended to be limited only by the scope of the appended claims.

## Claims

1. A method of forming transmission lines in an integrated circuit structure having a metal ground plane, comprising:
forming a dielectric layer on the ground plane;
forming at least one microstrip transmission line on the dielectric layer;
removing the dielectric layer from regions outside each line to form a standoff line supported on a post of dielectric material underneath each line.

2. The method of Claim 1 comprising removing the dielectric layer down to the ground plane.

3. The method of Claim 1 comprising removing the dielectric layer by directional etching.

4. The method of Claim 3 comprising removing the dielectric layer by reactive ion etching.

5. The method of Claim 3 further comprising coating each microstrip line with a mask material to form a mask for etching the dielectric layer.

6. The method of Claim 5 comprising coating each line with carbon.

7. The method of Claim 1 comprising forming the dielectric layer of $SiO_2$ or polyimide.

8. The method of Claim 1 comprising forming the dielectric layer with a thickness of about 10 microns.

9. The method of Claim 1 further comprising forming additional dielectric layers and forming transmission lines on the additional layers prior to removing dielectric material to form a multilevel transmission line structure.

10. The method of Claim 1 wherein the microstrip lines are formed by:
depositing in sequence on the dielectric layer a metal layer and at least one mask layer on the metal layer;
patterning the at least one mask layer to selectively expose areas where metal lines are desired;
forming metal lines by electrolytically depositing metal using the exposed areas of the metal layer as a nucleation site;
removing the remaining parts of the at least one mask layer down to the metal layer;
removing the exposed metal layer surrounding the metal lines.

11. The method of Claim 10 comprising:
forming the at least one mask layer of amorphous silicon on $SiO_2$;
patterning the amorphous silicon layer by laser etching;
patterning the $SiO_2$ layer by wet chemical etching, plasma etching or reactive ion etching;
forming the metal lines by electroless plating or electroplating.

12. The method of Claim 10 comprising:
forming the at least one mask layer of a layer of photoresist;
patterning the at least one mask layer by exposing and developing the photoresist;
forming the metal lines by electroless plating or electroplating.

13. The method of Claim 1 wherein the microstrip lines are fabricated by:
forming very thin metal wires on the dielectric layer;
plating metal onto the thin wires to increase wire size and reduce resistance.

14. The method of Claim 1 wherein the microstrip lines are fabricated by:
depositing in sequence a metal layer and at least one mask layer on the metal layer;
patterning the at least one mask layer to form a mask on the metal layer;
removing metal from the metal layer using the mask to leave freestanding metal lines.

15. The method of Claim 14 comprising:
forming the at least one mask layer of an amorphous silicon layer on top of a dielectric layer;
patterning the amorphous silicon layer by laser etching;
patterning the dielectric layer by reactive ion etching, plasma etching or wet chemical etching;
removing metal from the metal layer by ion milling, electropolishing, plasma etching or wet chemical etching.

16. The method of Claim 14 comprising:
forming the at least one mask layer of a layer of photoresist;
patterning the at least one mask layer by exposing and developing the photoresist;
removing the metal from the metal layer by ion milling, electropolishing, plasma etching or wet chemical etching.

17. An improved microstrip transmission line structure formed on an integrated circuit wafer and having higher characteristic impedance, less crosstalk, increased signal propagation velocities, and reduced wafer stress, comprising:
a metal ground plane formed on the wafer;
at least one metal microstrip transmission line spaced over the ground plane;
a post of dielectric material under each line separating the metal transmission line from the ground plane.

18. The structure of Claim 17 further comprising a plurality of microstrip transmission lines arranged in different levels above the ground plane.

19. The structure of Claim 17 wherein the post of dielectric material has a height of about 10 microns.

20. The structure of Claim 17 wherein the post of dielectric material is $SiO_2$ or polyimide.

28     12     28     12     10     28

| METAL LINE | | METAL LINE |

DIELECTRIC    ($\epsilon = 3.8$ FOR $SiO_2$)    14

GROUND PLANE    16

# FIG. 1

( PRIOR ART )

20     26     20     18

| METAL LINE | | METAL LINE |

22    AIR   | DIELECTRIC |   AIR   | DIELECTRIC |   AIR($\epsilon = 1$)   22

GROUND PLANE    24

# FIG. 2

METALIZE DIELECTRIC
(DEPOSIT ADHESION
LAYER, GOLD LAYER
ADHESION LAYER)

↓

DEPOSIT PHOTORESIST
ON METAL

↓

EXPOSE PHOTORESIST

↓

DEVELOP PHOTORESIST

↓

REMOVE METAL BY
ETCHING LEAVING
METAL WIRES

# FIG. 3

METALIZE DIELECTRIC
(DEPOSIT ADHESION
LAYER, GOLD LAYER
ADHESION LAYER)

↓

DEPOSIT $SiO_2$
ON METAL

↓

DEPOSIT $a$-$Si$
ON $SiO_2$

↓

ETCH (LASER) $a$-$Si$

↓

ETCH (RIE) $SiO_2$

↓

REMOVE METAL BY
ETCHING LEAVING
METAL WIRES

# FIG. 4

PHOTORESIST

Cr

## FIG. 5A

DIELECTRIC

EXPOSE PHOTORESIST

## FIG. 5B

DEVELOP PHOTORESIST

## FIG. 5C

Au

Cr

## FIG. 5D

Au

Cr

## FIG. 5E

Au
Cr

## FIG. 5F

a-Si
SiO₂
Cr

**FIG. 6A**

DIELECTRIC (SiO₂)

LASER ETCH

a-Si
SiO₂
Cr

**FIG. 6A**

RIE ETCH

a-Si
SiO₂
Cr

**FIG. 6C**

Au

a-Si
SiO₂
Cr

**FIG. 6D**

Au

Cr

**FIG. 6E**

Au  Cr

**FIG. 6F**

European Patent Office

# EUROPEAN SEARCH REPORT

Application Number

EP 89 30 7298

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-3 769 619  (ANG et al.)<br>* Abstract; figure 2, claim 2 * | 1,20 | H 01 P   3/08<br>H 01 P  11/00 |
| X | | 17 | |
| | --- | | |
| A | I.E.E. PROCEEDINGS-H/MICROWAVES, ANTENNAS & PROPAGATION, vol. 135, no. 3, part H, June 1988, pages 145-157, Stevenage, Herts GB; F.E. GARDIOL: "Design and layout of microstrip structures"<br>----- | | |

TECHNICAL FIELDS
SEARCHED (Int. Cl.5)

H 01. P
H 01 L

The present search report has been drawn up for all claims

| Place of search | Date of completion of the search | Examiner |
|---|---|---|
| THE HAGUE | 02-11-1989 | PHEASANT N.J. |

EPO FORM 1503 03.82 (P0401)